# EUROPÄISCHE PATENTSCHRIFT

(11) **EP 0 790 647 B1**
(45) Veröffentlichungstag und Bekanntmachung des Hinweises auf die Patenterteilung: **21.04.2004**
(21) Anmeldenummer: 97102700.8
(22) Anmeldetag: 19.02.1997
(51) Int. Cl.: H01L 23/492, H01L 21/60, H01L 23/482

(54) **Halbleiterkörper mit Lotmaterialschicht und Verfahren zum Auflöten des Halbleiterkörpers auf eine metallene Trägerplatte**
Semiconductor body having a solder layer and method of soldering the semiconductor body on a metal suppporting plate
Corps semi-conducteur ayant une couche de soudure et procédé de soudage du corps semi-conducteur sur une plaque métallique de support

(30) Priorität: 19.02.1996 DE 19606101
(43) Veröffentlichungstag der Anmeldung: 20.08.1997
(73) Patentinhaber: Infineon Technologies AG, 81669 München (DE)
(72) Erfinder: Hübner, Holger, Dr.rer.nat., 85598 Baldham (DE); Schneegans, Manfred, Dr.rer.nat., Dipl.-Phys., 85591 Vaterstetten (DE)
(74) Vertreter: Kindermann, Peter, Dipl.-Ing.

(56) Entgegenhaltungen:
- DE-A- 2 522 773
- DE-A- 3 406 542
- DE-A- 3 823 347
- DE-U- 9 212 486

## Beschreibung

Die Erfindung bezieht sich auf einen aus Silizium bestehenden Halbleiterkörper, der mit einer metallenen Trägerplatte über eine Folge von Metallschichten verlötbar ist, die vor dem Löten ausgehend vom Silizium in Richtung zur Trägerplatte eine Aluminiumschicht und eine Diffusionssperrschicht enthält.

Solche Halbleiterkörper, wie sie beispielsweise aus der DE 92 124 864 bekannt sind, sind in Halbleiterbauelemente, insbesondere in Leistungs-Halbleiterbauelemente, eingebaut, die sich in großer Zahl am Markt befinden. Die Folge von Metallschichten enthält in der Regel eine Aluminiumschicht, die auf einem Silizium-Halbleiterkörper sitzt. Die Aluminiumschicht haftet gut auf Silizium und bildet insbesondere mit p-dotiertem Silizium einen einwandfreien ohmschen Kontakt. Auf der Aluminiumschicht sitzt nach dem Stand der Technik eine Diffusionssperrschicht, die zumeist aus Titan oder Chrom besteht und als Haftvermittler und Rückseitenbarriere zwischen einer auf der Diffusionsperrschicht sitzenden Nickelschicht und der Aluminiumschicht dient. Auf die Nickelschicht wird nach dem Stand der Technik direkt oder auf eine darauffolgende dünne Titanschicht, die zur Haftungsverbesserung dient, eine Edelmetallschicht aufgebracht, die zumeist aus Silber, Gold oder Palladium besteht und als Oxidationsschutz für die Nickelschicht dient.

Beim eigentlichen Lötvorgang wird zwischen die so metallisierte Halbleiterkörperrückseite und die metallene Trägerplatte meist ein Lötplättchen gelegt, das zumeist aus Zinn und einem Flußmittel besteht. Beim Lötvorgang schmilzt dann die zwischen die Trägerplatte und die Silberschicht des Halbleiterkörpers eingelegte Lotschicht auf, wobei dann die Silberschicht aufgelöst wird und die folgenden Nickelschicht vom Lötmaterial angelöst wird und die Lötverbindung hergestellt wird.

Dieses allgemein bekannte Lötverfahren weist aber große Nachteile auf. Zum einen werden durch die unterschiedlichen thermischen Ausdehnungskoeffizienten von Nickel und dem Silizium-Halbleiterkörper mechanische Spannungen verursacht, die insbesondere bei dünnen Halbleiterkörpern (Dicke ≤ 250 µm) zu starken Waferverbiegungen (Verbiegungen > 1000 µm) führen.

Dadurch ist das "Handling" der Wafer erschwert, es kommt zu vermehrten Kassetten-Positionierfehlern und es tritt vermehrt eine Bruchgefahr beim Bearbeiten der Wafer auf.

Diesem Problem wurde bisher damit begegnet, daß versucht wurde, die Nickel-Schichtdicke soweit zu minimieren, daß die Lötung noch ausreichende Haftfestigkeit zeigte. Trotz reduzierter Nickel-Schichtdicke (≈ 1 µm) treten aber dennoch im Fertigungsbetrieb weiterhin Scheibenverbiegungen von 700 bis 2000 µm auf; die zu den obengenannten Problemen führen.

Ferner ist aus der Druckschrift DE 38 23 347 A ein verlötbarer Silizium-Halbleiterkörper mit einer Metallschichtenfolge bekannt, die eine Aluminiumschicht, eine Diffusionssperrschicht und eine Lotmaterialschicht aufweist. Die Lotmaterialschicht besteht hierbei aus einer Ni- oder Ni-/Cu-Schicht, weshalb zur Vermeidung einer unerwünschten Oxidation ferner Edelmetall-Abdeckschichten aus Gold oder Palladium verwendet werden.

Aufgabe der vorliegenden Erfindung ist es daher, einen Silizium-Halbleiterkörper derart zu metallisieren, daß bei jeringen hosten die Scheibenverbiegungen deutlich reduziert werden ohne dabei Einbußen in der Haftfestigkeit auf den Trägermaterialien zu erleiden.

Diese Aufgabe wird dadurch gelöst, daß auf der Diffusionssperrschicht eines Silizium-Halbleiterkörpers der eingangs genannten Art eine Zinn- oder Blei- oder Galliumschicht als Lotmaterialschicht aufgebracht ist.

Ein solcher Halbleiterkörper wird dann typischerweise auf die metallene Trägerplatte aufgelötet, in dem dieser auf die Trägerplatte aufgebracht wird und durch Erwärmen auf Temperaturen oberhalb von etwa 250°C unmittelbar, d.h. ohne Zufügen von weiteren Lötmitteln und Flußmitteln, mit der Trägerplatte verlötet wird.

Dadurch werden nahezu spannungsfreie Lotschichten erzeugt, die zu Substratverbiegungen von weniger als 300 µm führen. Ferner ist die Haftfestigkeit der gelöteten Halbleiterkörper auf den Trägerplatten sehr hoch, d.h. in Bereichen von größer 30 MPa. Des weiteren treten keine Versprödungen in Folge von Temperatur-Wechselbelastungen auf, da die metallischen Phasen nur dünn ausgeprägt sind. Insgesamt sind somit die Probleme im "Handling" der Wafer und die Bruchgefahr beseitigt.

Darüber hinaus kann mit den erfindungsgemäß metallisierten Halbleiterkörpern und dem erfindungsgemäßen Verfahren eine deutliche Kostenreduzierung erzielt werden, da die Materialkosten, insbesondere durch das Wegfallen einer Oxidationsschutzschicht, gesenkt und der Durchsatz erhöht werden können. Ferner ist das erfindungsgemäße Verfahren auch besonders umweltfreundlich, da durch die Flußmittelfreiheit Reinigungsschritte mit FCKW-Lösemitteln entfallen.

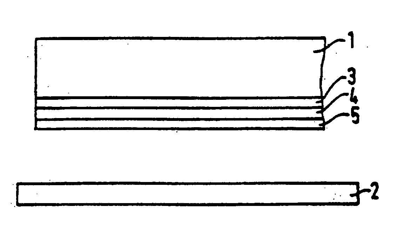

In der Figur ist die Schichtfolge der Metalle vor dem Verlöten gezeigt. Gemäß der Erfindung ist auf dem Halbleiterkörper 1 eine Aluminiumschicht 3 aufgebracht, die auf Silizium gut haftet und insbesondere mit p-dotiertem Silizium einen einwandfreien ohmschen Kontakt bildet. Auf der Aluminiumschicht 3 sitzt eine Diffusionssperrschicht 4, die aus Chrom oder Titan besteht mit einer Dicke von ca. 50 nm. Diese Schicht wird entweder direkt auf die Aluminiumschicht 3 gesputtert oder direkt aufgedampft. Auf der Diffusionssperrschicht 4 ist eine Haftvermittlerschicht z.B. Cu aufgebracht (nicht gezeigt) oder das Lotmaterial direkt aufgebracht. Die Lotschicht ist entweder aus Zinn, Gallium oder Blei besteht und eine Dicke von 1000 bis 3000 nm, bei der Verwendung von Zinn typischerweise eine Dicke von ungefähr 2700 nm beträgt. Der so metallisierte Silizium-Halbleiterkörper 1 wird dann auf die metallene Trägerplatte 2 gedrückt, die in der Regel aus Kupfer besteht, und bei ungefähr 300° C unter einer Schutzgasatmosphäre oder unter Vakuumbedingungen mit dieser verbunden, wobei eine metallurgische Verbindung zwischen Diffusionssperrschicht 4, Lotmaterialschicht 5 und Trägerplatte 2 entsteht, die bis zu einer Temperatur von ca. 450° C stabil ist.

Bei Anwendung des erfindungsgemäßen Verfahrens wird ein Produkt von hoher Qualität erzeugt, da die beschriebene Schichtenfolge einen besonders guten mechanisch und elektrisch stabilen Kontakt ergibt. Insbesondere ist das Verfahren sowohl unter technologischen als auch ökonomischen und ökologischen Gesichtspunkten gegenüber dem Stand der Technik als sehr vorteilhaft zu bezeichnen.

Technologisch wird durch das erfindungsgemäße Verfahren die Möglichkeit eröffnet, die Dicken der Silizium-Halbleitersubstrate weiter zu verringern, was zur Verbesserung der Durchlaßeigenschaften bei Leistüngs-Halbleiterbauelementen führt. Ökonomisch liegen die Vorteile darin, daß die Materialkosten reduziert werden können und der Durchsatz in der Fertigung erhöht werden kann. Schließlich liegt noch der ökologische Vorteil des erfindungsgemäßen Verfahrens darin, daß ohne Flußmittel gelötet wird, so daß sich dadurch Reinigungsschritte mit FCKW-haltigen Lösungsmitteln vermeiden lassen.

## Patentansprüche

1. Folge von Metallschichten auf einem aus Silizium bestehenden Halbleiterkörper (1) bestehend aus, vom Halbleiterkörper (1) ausgehend, einer Aluminiumschicht (3) und einer Diffusiorissperrschicht (4),
**dadurch gekennzeichnet, dass** direkt auf der Diffusionssperrschicht (4) eine Zinn- oder Blei- oder Galliumschicht als Lotmaterialschicht (5) aufgebracht ist.

2. Folge von Metallschichten nach Patentanspruch 1, **gekennzeichnet durch** eine Dicke der Diffusionssperrschicht (4) von etwa 50 nm.

3. Folge von Metallschichten nach Patentanspruch 1 oder 2, **gekennzeichnet durch** eine Dicke der Lotmaterialschicht (5) von weniger als 3000 nm.

4. Folge von Metallschichten auf einem aus Silizium bestehenden Halbleiterkörper (1) nach einem der Patentansprüche 1 bis 3, über die besagter Halbleiterkörper (1) mit einer metallenen Trägerplatte (2) verlötet ist.

5. Verfahren zum Auflöten eines aus Silizium bestehenden Halbleiterkörpers (1) auf eine metallene Trägerplatte (2), **dadurch gekennzeichnet, dass** eine Folge von Metallschichten auf einem aus Silizium bestehenden Halbleiterkörper (1) nach einem der Patentansprüche 1 bis 3 auf eine Trägerplatte (2) aufgebracht wird und durch Erwärmen auf Temperaturen oberhalb von 250°C besagter Halbleiterkörper (1) über besagte Folge von Metallschichten unmittelbar mit besagter Trägerplatte (2) verlötet wird.

## Claims

1. Sequence of metal layers on a semiconductor body (1) composed of silicon, comprising, proceeding from the semiconductor body (1), an aluminium layer (3) and a diffusion barrier layer (4)
**characterized in that** a tin or lead or gallium layer is applied as the solder material layer (5) directly to the diffusion barrier layer (4).

2. Sequence of metal layers according to Patent Claim 1, **characterized by** a thickness of the diffusion barrier layer (4) of about 50 nm.

3. Sequence of metal layers according to Patent Claim 1 or 2, **characterized by** a thickness of the solder material layer (5) of less than 3000 nm.

4. Sequence of metal layers on a semiconductor body (1) composed of silicon according to one of Patent Claims 1 to 3, by means of which the said semiconductor body (1) is soldered to a metal mount (2).

5. Method for soldering a semiconductor body (1) composed of silicon onto a metal mount (2), **characterized in that** a sequence of metal layers on a semiconductor body (1) composed of silicon according to one of Patent Claims 1 to 3 is applied to a mount (2) and, by heating to temperatures above 250°C, the said semiconductor body (1) is soldered directly to the said mount (2) by means of the said sequence of metal layers.

## Revendications

1. Succession de couches métalliques sur un corps (1) semi-conducteur en silicium, constituée à partir du corps (1) semi-conducteur, d'une couche (3) en aluminium et d'une couche (4) d'arrêt de la diffusion, **caractérisée en ce qu'**il est déposé directement sur la couche (4) d'arrêt de diffusion, comme couche (5) de matières de brasure, une couche d'étain ou de plomb ou de gallium.

2. Succession de couches métalliques suivant la revendication 1, **caractérisée par** une épaisseur de la couche (4) d'arrêt de diffusion d'environ 50 µm.

3. Succession de couches métalliques suivant la revendication 1 ou 2, **caractérisée par** une épaisseur de la couche (5) de matière de brasure de moins de 300 µm.

4. Succession de couches métalliques sur un corps semi-conducteur en silicium suivant l'une des revendications 1 à 3, par laquelle le corps (1) semi-conducteur est brasé à une plaque (2) métallique servant de support.

5. Procédé de brasage d'un corps (1) semi-conducteur en silicium sur une plaque (2) métallique servant de support, **caractérisé en ce que** l'on dépose sur une plaque (2) servant de support une succession de couches métalliques sur un corps (1) semi-conducteur en silicium suivant l'une des revendications 1 à 3 et, en portant le corps (1) semi-conducteur à des températures supérieures à 250°C, on le brase par la succession de couches métalliques directement à la plaque (2) servant de support.
